# EUROPÄISCHE PATENTANMELDUNG

(11) **EP 3 231 891 A1**
(43) Veröffentlichungstag der Anmeldung: **18.10.2017**
(21) Anmeldenummer: 17164702.7
(22) Anmeldetag: 04.04.2017
(51) Int. Cl.: C23C 16/513, C23C 16/453, C23C 16/40, C23C 4/134, C23C 4/04

(54) **VERFAHREN ZUR BESCHICHTUNG VON OBERFLÄCHEN**

(30) Priorität: 11.04.2016 DE 102016206006
(71) Anmelder: Innovent e.V., 07745 Jena (DE)
(72) Erfinder: BEIER, Oliver, 07407 Rudolstadt (DE); SPANGE, Sebastian, 07745 Jena (DE); RAMM, Max, 07768 Kahla (DE); GRÜNLER, Bernd, 07937 Zeulenroda-Triebes (DE)
(74) Vertreter: Liedtke, Markus

(57) **Zusammenfassung**

Die Erfindung betrifft ein Verfahren zum Beschichten eines Substrats, wobei mittels chemischer Gasphasenabscheidung unter Normaldruckbedingungen unter Verwendung eines nicht-thermischen Plasmas oder mittels eines Sol-Gel-Verfahrens ein Naturstoff auf einer Oberfläche des Substrats abgeschieden wird.

## Beschreibung

Die Erfindung betrifft ein Verfahren zur Beschichtung von Oberflächen.

Die Abscheidung von Kompositschichten mittels plasmaunterstützter chemischer Gasphasenabscheidung bei Atmosphärendruck (APCVD) ist bekannt, beispielsweise aus der DE 10 2012 210 807 A1.

Der Erfindung liegt die Aufgabe zu Grunde, ein verbessertes Verfahren zur Beschichtung von Oberflächen anzugeben.

Die Aufgabe wird erfindungsgemäß gelöst durch ein Verfahren mit den Merkmalen des Anspruchs 1.

Vorteilhafte Ausgestaltungen der Erfindung sind Gegenstand der Unteransprüche.

Bei einem erfindungsgemäßen Verfahren zum Beschichten eines Substrats wird mittels chemischer Gasphasenabscheidung unter Normaldruckbedingungen unter Verwendung eines nicht-thermischen Plasmas mindestens ein Naturstoff auf einer Oberfläche des Substrats abgeschieden.

Weiterhin ist es möglich beim erfindungsgemäßen Verfahren zum Beschichten eines Substrates mittels Sol-Gel Technik unter Normaldruck und Auftrag mittels Tauch-, Sprüh-, Düsen-, Schleuderauftrags oder Rakeln einen Naturstoff auf einer Oberfläche eines Substrates abzuscheiden.

Überraschenderweise hat sich gezeigt, dass die Abscheidung organischer Verbindungen, insbesondere von Naturstoffen, das heißt nichtsynthetischen organischen Verbindungen, beispielsweise Extrakten aus Pflanzen, Tieren, Pilzen oder Bakterien oder deren Stoffwechselprodukten mittels eines nicht-thermischen Plasmas oder mittels des Sol-Gel-Verfahrens möglich ist. Dadurch können lokal begrenzte Mengen der organischen Verbindungen oder Naturstoffe auf dem Substrat gezielt appliziert werden.

In einer Ausführungsform wird der Naturstoff dem Plasma in gelöster Form zugeführt und gezielt in feine Aerosole zerstäubt. Alternativ dazu kann der Naturstoff dampfförmig oder in fest/flüssig dispergierter Form als Mikro- oder Nanopartikel zugeführt werden. Bei der gezielten Überführung des Naturstoffs in die Dampfphase können Lösungsmittel für die Verarbeitung substituiert werden. In einer Ausführungsform des Sol-Gel-Prozesses liegen die Naturstoffe in gelöster oder nanopartikulärer Form vor und werden mit den eine Schichtmatrix bildenden Komponenten des Sol-Systems vermischt und appliziert.

In einer Ausführungsform wird das Plasma in einer Freistrahlplasma-Quelle erzeugt. Bei diesem Verfahren wird eine Hochfrequenzentladung zwischen zwei konzentrischen Elektroden gezündet, wobei durch einen angelegten Gasstrom das sich bildende Hohlkathodenplasma als Plasmajet aus der Elektrodenanordnung in aller Regel mehrere Zentimeter in den freien Raum und zur zu beschichtenden Oberfläche herausgeführt wird. Ein Precursor kann sowohl vor der Anregung in das Arbeitsgas (direct plasma processing) als auch danach in das bereits gebildete Plasma oder in dessen Nähe (remote plasma processing) eingeleitet werden. Eine weitere Möglichkeit der Plasmaerzeugung ist das Ausnutzen einer dielektrisch behinderten Entladung (DBE), beispielsweise in Form von Volumen-Barriereentladungen oder Oberflächen-Barriereentladungen. Bei diesen Entladungstypen findet die Plasmaerzeugung zumeist an Umgebungsluft statt, es können aber auch gezielt Arbeitsgase oder Gasgemische durch die Elektrodenanordnung hindurchgeleitet werden. Die Plasmaentladung erfolgt zwischen den Elektroden, welche mit hochfrequenter Hochspannung gespeist werden.

In einer Ausführungsform wird der Naturstoff in Form von Partikeln durch das Plasma auf der Oberfläche abgeschieden.

In einer weiteren Ausführungsform wird zusätzlich zum Naturstoff mindestens ein Precursor dem Plasma zugeführt und energetisch so umgewandelt, dass eine Schicht aufwächst, wobei der Naturstoff durch das Plasma in der aufwachsenden Schicht eingelagert wird. Auf diese Weise wird der Naturstoff immobilisiert und kann daher nicht so leicht wieder von der Oberfläche entfernt werden.

In einer Ausführungsform wird als Naturstoff ein entzündungshemmendes Material, eine antimikrobielle oder fungizide Verbindung, ein Geruchsstoff oder ein das Zellwachstum fördernder Stoff verwendet. Beispielsweise können als Geruchsstoff ätherische Öle von Pflanzen der Gattung Mentha genutzt werden. Das hierbei enthaltene Menthol kann auf den Kälte-Menthol-Rezeptor wirken und einen kühlenden Effekt hervorrufen, der jedoch nicht die eigentliche Temperatur beeinflusst. Als Wachstumsfördernder Stoff oder Apoptose verhindernder Naturstoff kann Betulinumsäure verwendet werden. Dieser Naturstoff regt in-vitro die Mitochondrien zur Freisetzung von apoptogenen Faktoren an.

Im Stand der Technik werden bislang für die Erzeugung antimikrobieller oder fungizider Schichten ausschließlich anorganische Wirkstoffe verwendet, beispielsweise auf Basis von Silber, Kupfer oder Zink. Zumeist bilden dabei Salze der genannten Metalle oder Nanopartikeldispersionen die Ausgangsstoffe. Durch das erfindungsgemäße Verfahren ist es möglich, auch antimikrobielle oder fungizide Naturstoffe abzuscheiden. Der Vorteil vieler organischer Verbindungen ist deren teilweise oder völlige Resorbierbarkeit im Körper. Weiterhin sind die Wirkungsmechanismen vieler organischer Verbindungen zu anorganischen Verbindungen verschieden. Auch bestehen zu einigen anorganischen Verbindungen Allergien oder Unverträglichkeiten, somit lassen sich bei Verwendung des beschichteten Substrats im Kontakt mit dem menschlichen Körper, beispielsweise zu Therapiezwecken, durch Verwendung organischer Verbindungen alternative Therapiemöglichkeiten erschließen.

In einer Ausführungsform wird als Substrat ein Implantat, beispielsweise ein Metallimplantat beschichtet. In einer Ausführungsform wird als Substrat ein Textil, beispielsweise ein Verbandstoff oder Bekleidung beschichtet. Weiteres Anwendungspotential bietet sich für Holzoberflächen, zum Beispiel Holzschutz, insbesondere zum Schutz vor Umwelteinflüssen und Schädlingsbefall im konstruktiven Bereich, Konservierung, Schutz von Kulturgütern. Ebenso können Substrate aus Glas, Keramik, Kunststoffen, beispielsweise Polymeren, Metallen / Legierungen, Verbundwerkstoffen, Holz, Fasern, Papier, Folien beschichtet werden. Das beschriebene Verfahren der Beschichtung von Substraten mit Naturstoffen mit fungizider oder antibakterieller Wirkung kann auch für Verpackungen, beispielsweise für Lebensmittel, Einmalverpackungen, Operationsbesteck, wiederverwendbare Systeme verwendet werden. Hierbei ist die Abbaubarkeit und Unbedenklichkeit bei der Wiederverwertung entscheidend.

In einer Ausführungsform wird als Naturstoff zumindest Weihrauch und/oder ein Nadelbaumharz (Kolophonium) und/oder Gentamycin und/oder Tryptanthrin und/oder Tannin abgeschieden. Weiterhin können Naturstoffe wie Betulinumsäure, Mistellektin, Helenalin, Epigallocatechin, Resveratrol, Curcumin, Genistein, Boswelliasäuren oder Nelkenöl abgeschieden werden.

In einer Ausführungsform umfasst die aufwachsende Schicht eine Matrix aus SiOₓ oder TiOₓ.

In einer Ausführungsform erfolgt die Abscheidung mit einer elektrischen Leistung des Plasmas im Bereich von 100 W bis 1000 W, bevorzugt unterhalb 500 W und besonders bevorzugt zwischen 200 W und 400 W, insbesondere von 250 W.

Die Erfindung betrifft weiter ein Substrat, umfassend eine Oberfläche, auf der ein entzündungshemmendes Material, eine antimikrobielle oder fungizide Verbindung oder ein das Zellwachstum fördernder Stoff mittels des oben beschriebenen Verfahrens abgeschieden ist. Das Substrat kann beispielsweise ein Implantat aus Metall sein. Beispielsweise kann Weihrauch und/oder ein Nadelbaumharz und/oder Gentamycin und/oder Tryptanthrin und/oder Tannin auf dem Substrat abgeschieden sein. In einer Ausführungsform ist das Substrat ein Textil, beispielsweise ein Verbandstoff oder Bekleidung. Ebenso kann das Substrat eine Holzoberfläche sein, die zum Zwecke des Holzschutzes, insbesondere zum Schutz vor Umwelteinflüssen und Schädlingsbefall im konstruktiven Bereich, Konservierung, Schutz von Kulturgütern mit dem erfindungsgemäßen Verfahren beschichtet ist. Ebenso kann das Substrat aus Glas, Keramik, Kunststoffen, beispielsweise Polymeren, Metallen / Legierungen, Verbundwerkstoffen, Holz, Fasern, Papier, Folien gebildet sein. Weiter kann das Substrat eine Verpackung, beispielsweise für Lebensmittel, Einmalverpackungen, Operationsbesteck oder wiederverwendbare Systeme sein.

Ausführungsbeispiele der Erfindung werden im Folgenden anhand von Zeichnungen näher erläutert.

Darin zeigen:
- Figur 1: ein Spektrogramm zum Nachweis einer organischen Komponente in einer abgeschiedenen Schicht
- Figur 2: eine Lumineszenz von E.coli Bakterien auf abgeschiedenem Nadelbaumharz im Vergleich zu einer unbelasteten E.coli Referenz,
- Figur 3: ein Spektrogramm zum Nachweis von Gentamycin und Tannin in einer abgeschiedenen Schicht,
- Figur 4: ein Spektrogramm zum Nachweis von Gentamycin Dodecylsulfat in einer abgeschiedenen Schicht,

- Figur 5: eine Lumineszenz von E.coli Bakterien auf abgeschiedenem Tryptanthrin, Gentamycin mit Tannin und Gentamycin Dodecylsulfat im Vergleich zu einer unbelasteten E.coli Referenz, und
- Figur 6: ein Spektrogramm zum Nachweis von Weihrauch, Gentamycin und Tanninsäure in abgeschiedenen Sol-Gel Schichten.

Ein erfindungsgemäßes Verfahren zur Beschichtung einer Oberfläche eines Substrats mit mindestens einem Naturstoff, beispielsweise einem organischen Wirkstoff, erfolgt beispielsweise unter Verwendung von nicht-thermischen Plasmen unter Atmosphärendruck, wobei der Naturstoff in gelöster Form einem Plasmaprozess zugeführt wird. Als Plasmasystem kommt beispielsweise ein sogenanntes Freistrahlplasma zur Anwendung, das räumlich begrenzt mit der Oberfläche des Substrats interagiert. Bei diesem Verfahren wird eine Hochfrequenzentladung zwischen zwei konzentrischen Elektroden gezündet, wobei durch einen angelegten Gasstrom das sich bildende Hohlkathodenplasma als Plasmajet aus der Elektrodenanordnung in aller Regel mehrere Zentimeter in den freien Raum und zur zu beschichtenden Oberfläche herausgeführt wird. Der Precursor oder Naturstoff kann sowohl vor der Anregung in das Arbeitsgas (direct plasma processing) als auch danach in das bereits gebildete Plasma oder in dessen Nähe (remote plasma processing) eingeleitet werden. Eine weitere Möglichkeit der Plasmaerzeugung ist das Ausnutzen einer dielektrisch behinderten Entladung. Dabei wird das als Dielektrikum dienende Arbeitsgas, insbesondere Luft, zwischen zwei Elektroden hindurchgeleitet. Die Plasmaentladung erfolgt zwischen den Elektroden, welche mit hochfrequenter Hochspannung gespeist werden.

Der Naturstoff kann einmal in Form von Partikeln direkt durch das Plasma auf der Oberfläche lokal appliziert werden. Ebenso kann der Naturstoff auch in einer aufwachsenden Schicht eingelagert und somit immobilisiert werden. Für eine so zu bildende Kompositschicht wird mindestens ein Precursor dem Plasmaprozess zugeführt und energetisch so umgewandelt, dass eine Schicht, beispielsweise eine dünne, kompakte, wenige hundert Nanometer dicke Schicht aufwächst. Der mindestens eine Naturstoff kann aus einem weiten Spektrum von organischen Verbindungen ausgewählt sein, um gezielt Eigenschaften der Oberfläche anzupassen. Beispielsweise kann der mindestens eine Naturstoff ein entzündungshemmendes Material, eine antimikrobielle oder fungizide Verbindung, insbesondere ein Antibiotikum, oder auch ein Geruchsstoff oder ein das Zellwachstum fördernder Stoff sein. Einige exemplarische Verbindungen werden in den Ausführungsbeispielen angesprochen.

In einer alternativen Ausführungsform kann die Einbringung des mindestens einen Naturstoffs in Sole mit anschließender Applikation auf der Oberfläche, beispielsweise per Spin-, Dip-, Spraycoating, Rakeln oder Drucken, erfolgen. Eine Matrixschicht, in die die Wirkstoffe eingelagert werden, kann hier je nach Anwendungsform gezielt angepasst werden. Beispielsweise kann die Matrixschicht anorganische Netzwerke, insbesondere SiO₂, TiO₂ oder organisch modifizierte Sole umfassen, die direkt mit den Naturstoffen chemisch interagieren.

In einer Ausführungsform wird als Substrat ein Metallimplantat, beispielsweise umfassend Titan, in einem ersten Schritt elektrochemisch biokompatibel oder bioinert funktionalisiert, beispielsweise durch plasmachemische Oxidation. Hierbei wird die natürliche Oxidschicht verstärkt und Elektrolyt-Bestandteile gezielt in die Oxidschicht eingelagert. In einem zweiten Schritt wird der Naturstoff, wie zuvor beschrieben, mittels Plasma oder Sol-Gel Technik auf dieser Oberfläche abgeschieden.

In einer Ausführungsform der Erfindung wurde eine Lösung des Naturstoffs Weihrauch in Isopropanol (Bestandteile des Weihrauchs sind unter anderem Boswelliasäuren, ätherische Öle) mittels plasmaunterstützter chemischer Gasphasenabscheidung unter Atmosphärendruck auf ein Substrat, beispielsweise ein Metall-Substrat oder einen Silizium-Wafer, flächig abgeschieden. Hierfür wurde ein nicht-thermischer Plasmastrahl verwendet und die Weihrauchlösung als Aerosol dem Plasma zugeführt. Weihrauch als Naturstoff wird in der Fachliteratur entzündungshemmende oder desinfizierende Eigenschaften zugesprochen. Ein nicht-thermisches Plasma zeichnet sich dabei durch Unterschiede in der Elektronentemperatur und der Ionentemperatur aus. Da bei diesen Systemen oder Prozessen bevorzugt die Elektronen des Arbeitsgases (z.B. Luft, N₂, Ar) angeregt werden, liegen die Elektronentemperaturen um teilweise mehrere Größenordnungen höher als die Ionentemperaturen.

In einem weiteren Beispiel wurde dieselbe Weihrauchlösung verwendet, um den Wirkstoff in eine Schichtmatrix aus SiOₓ lokal einzubinden. Die Beschichtung erfolgte mittels plasmaunterstützter chemischer Gasphasenabscheidung unter Atmosphärendruck. Zusätzlich wurde dem Plasmaprozess eine schichtbildende chemische Vorläufersubstanz (Precursor) zugeführt, beispielsweise Hexamethyldisiloxan (HMDSO), um eine Siliziumoxidschicht abzuscheiden. Auf diese Weise wächst in einem Schritt eine dünne SiOₓ-Schicht auf der Substratoberfläche auf, in die der Naturstoff, im vorliegenden Fall Weihrauch, eingelagert wurde. Die Beschichtung kann sowohl flächig als auch lokal begrenzt erfolgen.

In beiden Beispielen kann eine flächige Beschichtung mit 250 W elektrischer Leistung des Plasmasystems und Luft als Arbeits-, sowie Trägergas erfolgen. In alternativen Ausführungsbeispielen liegt die Plasmaleistung für Beschichtungen im Bereich von 100 W bis 1000 W, bevorzugt unterhalb 500 W und besonders bevorzugt zwischen 200 W und 400 W. Das Substrat kann unter dem Plasmajet mäanderförmig verfahren und beispielsweise können insgesamt acht Beschichtungsdurchläufe durchgeführt werden, um beispielsweise eine insgesamt 100 nm bis 200 nm dicke Schicht zu erzeugen.

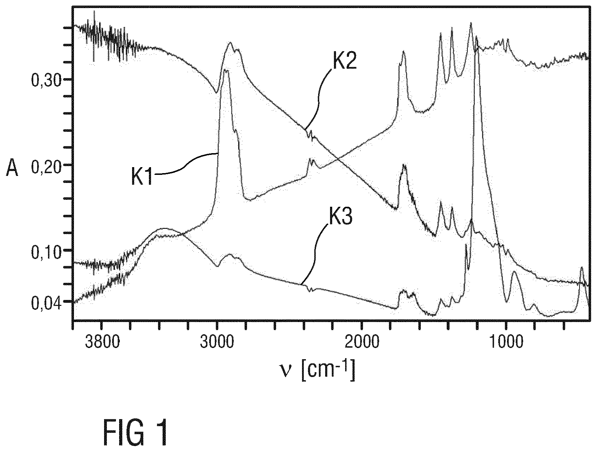

Figur 1 zeigt ein Spektrogramm zum Nachweis der organischen Komponente in der abgeschiedenen Schicht, wobei die Absorption A über der Wellenzahl v dargestellt ist. Der Nachweis wurde als Reflexionsmessung auf einem Substrat aus Edelstahl mittels FTIR - Spektroskopie durchgeführt. Kurve K1 zeigt das Absorptionsverhalten einer auf dem Substrat eingetrockneten Weihrauchlösung als nicht verarbeitete Referenz des Naturstoffes. Kurve K2 zeigt das Absorptionsverhalten einer auf dem Substrat mittels plasmaunterstützter chemischer Gasphasenabscheidung unter Atmosphärendruck abgeschiedenen Schicht aus Weihrauch. Kurve K3 zeigt das Absorptionsverhalten einer auf dem Substrat mittels plasmaunterstützter chemischer Gasphasenabscheidung unter Atmosphärendruck abgeschiedenen SiOₓ-Schicht, in die der Weihrauch eingelagert ist. In den mittels plasmaunterstützter chemischer Gasphasenabscheidung unter Atmosphärendruck abgeschiedenen Schichten lassen sich ebenfalls die Banden der Ausgangslösung bzw. des eingetrockneten Weihrauchs feststellen.

In einem weiteren Ausführungsbeispiel wird als Naturstoff Nadelbaumharz, verdünnt in Isopropanol als Precursor mittels APCVD abgeschieden und die erhaltene Schicht auf ihre antimikrobiellen Eigenschaften untersucht.

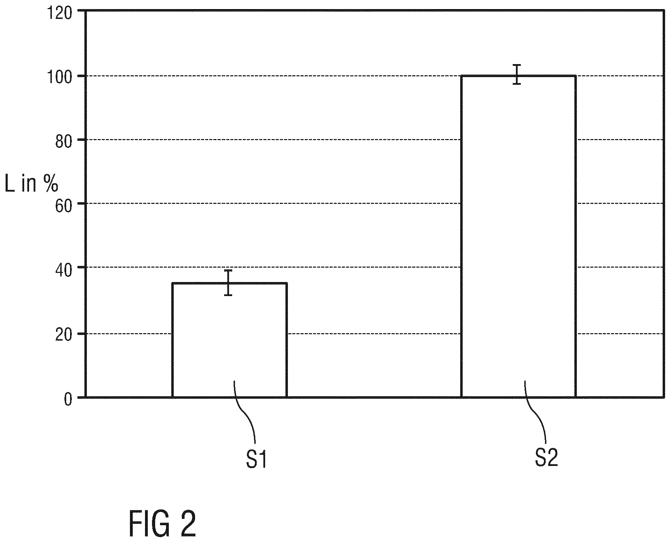

Der Nachweis erfolgte an E.coli Bakterien und einem standardisierten BacTiter-Glo Assay Test. Figur 2 zeigt eine Lumineszenz L der E.coli Bakterien auf dem abgeschiedenen Nadelbaumharz in Säule S1 im Vergleich zur unbelasteten E.coli Referenz in Säule S2. Dabei ist eine Verringerung des Wachstums durch das Nadelbaumharz zu erkennen.

In einem weiteren Ausführungsbeispiel wurde als Naturstoff Gentamycin, ein Aminoglycosid-Antibiotikum, mittels APCVD abgeschieden. Zwei Precursoren wurden getestet und mittels plasmaunterstützter chemischer Gasphasenabscheidung unter Atmosphärendruck auf den Trägersubstraten appliziert. Der erste Precursor stellt eine Mischung aus Gentamycin und Tannin dar, gelöst in Ameisensäure. Die Konzentration der Lösung betrug 10 Gew.-%. Als zweiter Precursor wurde die Substanz Gentamycin Dodecylsulfat auch in Ameisensäure gelöst zu 15 Gew.-% verwendet.

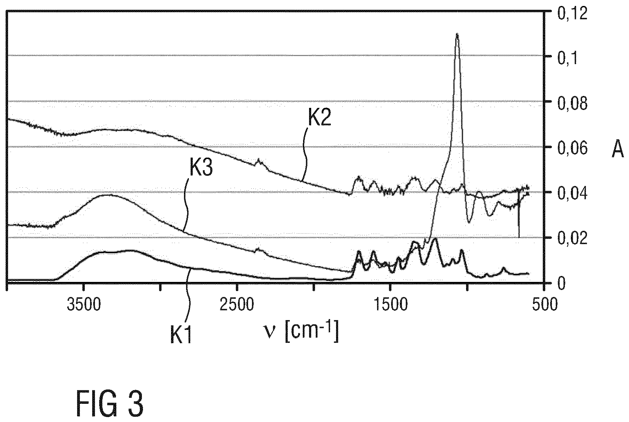

Figur 3 zeigt ein Spektrogramm zum Nachweis der organischen Komponente in der abgeschiedenen Schicht. Der Nachweis wurde als Transmissionsmessung auf einem Sililzium-Wafer als Substrat mittels FTIR - Spektroskopie durchgeführt. Kurve K1 zeigt das Absorptionsverhalten der auf dem Substrat eingetrockneten Lösung der Mischung aus Gentamycin und Tannin in Ameisensäure. Kurve K2 zeigt das Absorptionsverhalten einer auf dem Substrat mittels plasmaunterstützter chemischer Gasphasenabscheidung unter Atmosphärendruck abgeschiedenen Schicht aus Gentamycin und Tannin. Kurve K3 zeigt das Absorptionsverhalten einer auf dem Substrat mittels plasmaunterstützter chemischer Gasphasenabscheidung unter Atmosphärendruck abgeschiedenen SiOₓ-Schicht, in die der Gentamycin und Tannin eingelagert ist.

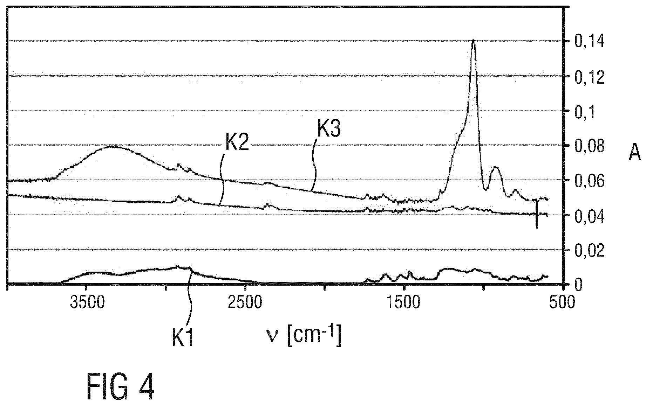

Figur 4 zeigt ein Spektrogramm zum Nachweis der organischen Komponente in der abgeschiedenen Schicht. Der Nachweis wurde als Transmissionsmessung auf einem Silizium-Wafer als Substrat mittels FTIR - Spektroskopie durchgeführt. Kurve K1 zeigt das Absorptionsverhalten der auf dem Substrat eingetrockneten Lösung aus Gentamycin Dodecylsulfat in Ameisensäure. Kurve K2 zeigt das Absorptionsverhalten einer auf dem Substrat mittels plasmaunterstützter chemischer Gasphasenabscheidung unter Atmosphärendruck abgeschiedenen Schicht aus Gentamycin Dodecylsulfat. Kurve K3 zeigt das Absorptionsverhalten einer auf dem Substrat mittels plasmaunterstützter chemischer Gasphasenabscheidung unter Atmosphärendruck abgeschiedenen SiOₓ-Schicht, in die der Gentamycin Dodecylsulfat eingelagert ist.

Für beide Gentamycin-Precursorarten lassen sich nach Plasmaabscheidung spezifische Absorptionsbanden zuordnen, die auch bei den Wirkstoffen der eingetrockneten Ausgangslösung zu finden sind. Eine gezielte Wirkstoff-Einlagerung in SiOₓ-Schichten ist ebenfalls möglich (Kurve 3). Zusätzlich erfolgten Versuche mit dem Naturstoff Tryptanthrin (0,025 Gew.-% gelöst in Methanol), einem Bestandteil des Färberwaids, welchem unter anderem insektizide und bakterielle / fungizide Wirkung zugesprochen wird. Diese Proben werden im gleichen Verlauf auf ihre bakterizide Wirkung gegenüber E.coli hin analysiert.

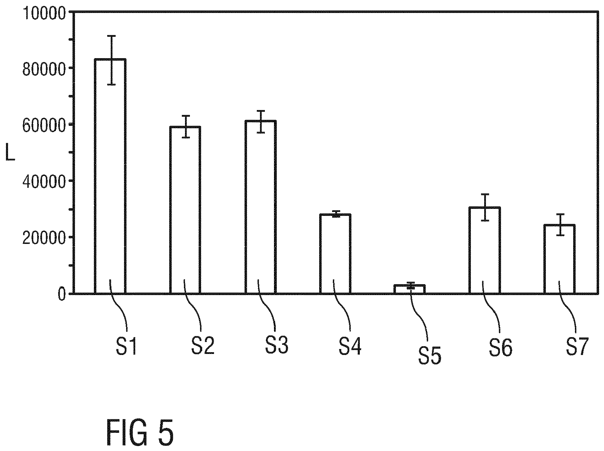

Figur 5 zeigt eine Lumineszenz L der E.coli Bakterien auf dem abgeschiedenen Tryptanthrin, Gentamycin mit Tannin und Gentamycin Dodecylsulfat im Vergleich zur unbelasteten E.coli Referenz. In Figur 5 sind die BacTiter-Glo Ergebnisse für Glas-Probekörper in Säule S1 dargestellt, wobei reine, unbeschichtete Gläser als Referenz dienen für ein ungestörtes Wachstum der E. Coli Bakterien.

Für Tryptanthrin sind Ergebnisse des eingetrockneten reinen Wirkstoffes auf Glas in Säule S2, und bei Abscheidung mittels plasmaunterstützter chemischer Gasphasenabscheidung unter Atmosphärendruck zur Erzeugung einer SiOₓ / Wirkstoff - Kompositbeschichtung in Säule S3 dargestellt.

Für Gentamycin / Tannin sind Ergebnisse des eingetrockneten reinen Wirkstoffes auf Glas in Säule S4, und bei Abscheidung mittels plasmaunterstützter chemischer Gasphasenabscheidung unter Atmosphärendruck zur Erzeugung einer SiOₓ / Wirkstoff - Kompositbeschichtung in Säule S5 dargestellt.

Für Gentamycin Dodecylsulfat sind Ergebnisse des eingetrockneten reinen Wirkstoffes auf Glas in Säule S6, und bei Abscheidung mittels plasmaunterstützter chemischer Gasphasenabscheidung unter Atmosphärendruck zur Erzeugung einer SiOₓ / Wirkstoff - Kompositbeschichtung in Säule S7 dargestellt.

Niedrige Lumineszenzwerte (RLU - relative luminescence units) bedeuten eine starke Schädigung der Bakterienzelle und somit eine starke bakterizide Wirkung. Für Werte oberhalb 50000 RLU liegt in dem Beispiel keinerlei bakterizide Wirkung vor. Im Falle von Tryptanthrin (S2 und S3) konnte allerdings eine leichte Hemmung des Wachstums im Vergleich zur Referenz S1 beobachtet werden.

Man erkennt bakterizide Eigenschaften für die Gentamycin-basierten Precursoren, jeweils etwas stärker für den eingetrockneten Wirkstoff als für die mittels plasmaunterstützter chemischer Gasphasenabscheidung unter Atmosphärendruck erzeugten Schichten. Dies liegt an der deutlich höheren aufgebrachten Menge - und ließ sich auch in den FTIR Untersuchungen anhand der Peakintensitäten verifizieren. Somit lassen sich auch mit diesen Wirkstoffen mittels plasmaunterstützter chemischer Gasphasenabscheidung unter Atmosphärendruck bakterizide Schichten herstellen.

Im Falle des Tryptanthrin ließ sich hier keine signifikante bakterizide Wirkung feststellen, was aber vermutlich durch die geringe Konzentration der Ausgangslösung zu erklären ist.

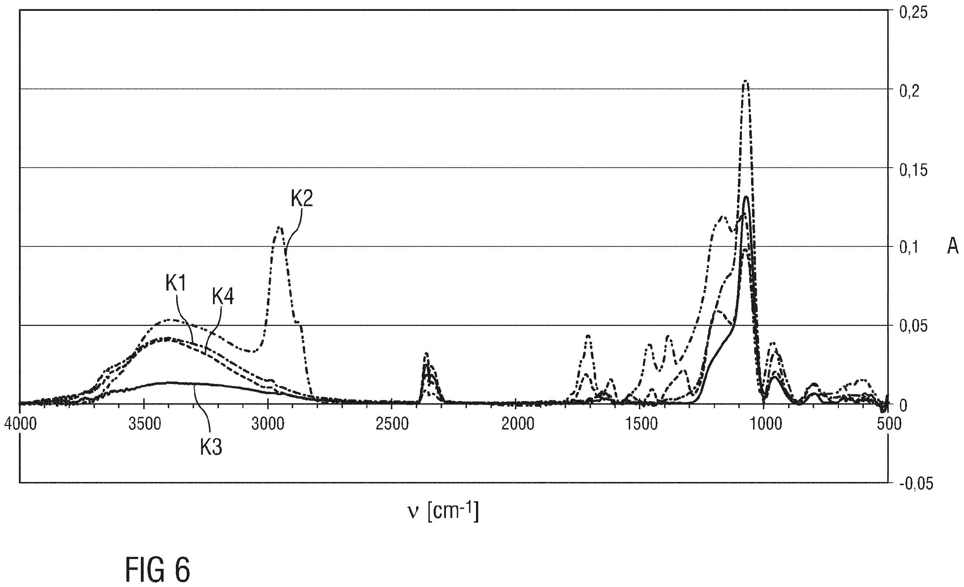

Figur 6 zeigt ein Spektrogramm zum Nachweise einer organischen Komponente in einer abgeschiedenen silikatischen Sol-Gel Schicht. Die modifizierte silikatische Schichtmatrix wurde mit einem Basis-Sol bestehend aus Tetraethylorthosilicat (TEOS) (34 Gew.% bis 35 Gew.%), Isopropanol
(53 Gew.%), 65%-ige Salpetersäure (0,2 Gew.%) und Wasser (12 Gew.%) erzeugt, in welches die gelösten Naturstoffe vollständig vermischt und mittels Tauch- oder Sprühbeschichtung appliziert werden. Anschließend werden die Schichten zunächst für eine Stunde bei Raumtemperatur und für eine weitere Stunde bei 130 °C getrocknet. Der Nachweis wurde als Transmissionsmessung auf einem Silizium-Wafer als Substrat mittels FTIR-Spektroskopie durchgeführt. Kurve K1 zeigt ein Absorptionsverhalten einer SiO₂ - Schicht aus dem reinen TEOS-basierten Sol ohne einen eingelagerten Naturstoff. Kurve K2 zeigt ein Absorptionsverhalten einer Schicht des TEOS-basierten Sols mit eingelagertem Weihrauch. Kurve K3 zeigt ein Absorptionsverhalten einer Schicht des TEOS-basierten Sols mit eingelagertem Gentamycin. Kurve K4 zeigt ein Absorptionsverhalten einer Schicht des TEOS-basierten Sols mit eingelagerter Tanninsäure. Für die Naturstoffe Weihrauch und Tanninsäure lassen sich eindeutig in den Sol-Gel Schichten spezifische Absorptionsbanden der Naturstoffe im Vergleich zu der reinen TEOS SiO₂-Schicht (K1) feststellen, für das Gentamycin konnte hier keine finale Aussage gewonnen werden.

Das beschriebene Verfahren der Beschichtung von Substraten mit Naturstoffen mit fungizider oder antibakterieller Wirkung kann auch für Verpackungen, beispielsweise für Lebensmittel, Einmalverpackungen, Operationsbesteck verwendet werden. Hierbei ist die Abbaubarkeit und Unbedenklichkeit bei der Wiederverwertung entscheidend. Die Techniken der nicht thermischen Plasmen und des Sol-Gel-Auftrages erlauben hierbei die Beschichtung einer Vielzahl von Materialien, welche in der Verpackungsindustrie genutzt werden, zum Beispiel Polyethylen, Polypropylen, PET, PS oder PLA.

Wirkstoffe für Implantatbeschichtungen können als Beispiel Gentamycin für eine antibakterielle Wirkung sein oder Betulinumsäure für ein unterstütztes Einwachsverhalten des Implantates.

Weihrauch als entzündungshemmender (antiinflammatorischer) Wirkstoff kann auf textilen Substraten aufgetragen werden, um für durch Neurodermitis geschädigte Personen eine bessere Hautverträglichkeit zu ermöglichen.

### BEZUGSZEICHENLISTE

- A: Absorption
- K1 bis K4: Kurve
- v: Wellenzahl
- L: Lumineszenz
- S1 bis S7: Säule

## Patentansprüche

1. Verfahren zum Beschichten eines Substrats, wobei mittels chemischer Gasphasenabscheidung unter Normaldruckbedingungen unter Verwendung eines nicht-thermischen Plasmas oder mittels eines Sol-Gel-Verfahrens ein Naturstoff auf einer Oberfläche des Substrats abgeschieden wird.

2. Verfahren nach Anspruch 1, wobei der Naturstoff dem Plasma in gelöster Form, als Aerosol, dampfförmig oder in dispergierter Form, zugeführt wird.

3. Verfahren nach einem der Ansprüche 1 oder 2, wobei das Plasma in einer Freistrahlplasma-Quelle erzeugt wird.

4. Verfahren nach einem der vorhergehenden Ansprüche, wobei der Naturstoff in Form von Partikeln durch das Plasma auf der Oberfläche abgeschieden wird.

5. Verfahren nach einem der Ansprüche 1 bis 4, wobei mindestens ein Precursor dem Plasma zugeführt und energetisch so umgewandelt wird, dass eine Schicht aufwächst, wobei der Naturstoff durch das Plasma in der aufwachsenden Schicht eingelagert wird.

6. Verfahren nach einem der vorhergehenden Ansprüche, wobei als Naturstoff ein entzündungshemmendes Material, eine antimikrobielle oder fungizide Verbindung, ein Geruchsstoff oder ein das Zellwachstum fördernder Stoff verwendet wird.

7. Verfahren nach einem der vorhergehenden Ansprüche, wobei als Substrat ein Implantat oder ein Textil oder ein Verbandsstoff oder eine Verpackung oder eine Holzoberfläche beschichtet wird.

8. Verfahren nach einem der Ansprüche 6 oder 7, wobei als Naturstoff zumindest Weihrauch und/oder ein Nadelbaumharz und/oder Gentamycin und/oder Tryptanthrin und/oder Tannin abgeschieden wird.

9. Verfahren nach einem der Ansprüche 5 bis 8, wobei die aufwachsende Schicht eine Matrix aus SiOₓ oder TiOₓ umfasst.

10. Substrat, umfassend eine Oberfläche, auf der ein entzündungshemmendes Material, eine antimikrobielle oder fungizide Verbindung oder ein das Zellwachstum fördernder Stoff mittels eines Verfahrens nach einem der vorhergehenden Ansprüche abgeschieden ist.
